# EUROPÄISCHE PATENTSCHRIFT

(11) **EP 3 646 414 B1**
(45) Veröffentlichungstag und Bekanntmachung des Hinweises auf die Patenterteilung: **19.11.2025**
(21) Anmeldenummer: 18714176.7
(22) Anmeldetag: 15.03.2018
(51) Int. Cl.: H01R 43/02, H01R 4/02, B23K 1/005, H01L 23/00, B23K 1/00, B23K 3/06, B23K 101/38

(54) **VERFAHREN ZUR HERSTELLUNG EINER BAUELEMENTANORDNUNG MIT DRAHTVERBINDUNG SOWIE BAUELEMENTANORDNUNG MIT DRAHTVERBINDUNG**
METHOD FOR PRODUCING A COMPONENT ARRANGEMENT WITH WIRE CONNECTION, AND COMPONENT ARRANGEMENT WITH WIRE CONNECTION
PROCÉDÉ POUR ÉTABLIR UN SYSTÈME DE COMPOSANTS COMPORTANT UNE LIAISON FILAIRE ET SYSTÈME DE COMPOSANTS COMPORTANT UNE LIAISON FILAIRE

(30) Priorität: 29.06.2017 DE 102017114530; 03.07.2017 DE 102017114771
(43) Veröffentlichungstag der Anmeldung: 06.05.2020
(73) Patentinhaber: Pac Tech - Packaging Technologies GmbH, 14641 Nauen (DE)
(72) Erfinder: KOLBASOW, Andrej, 14641 Paulinenaue (DE); HOFFMANN, Jan, 14552 Michendorf (DE); FETTKE, Matthias, 13053 Berlin (DE)
(74) Vertreter: advotec.
(86) Internationale Anmeldenummer: PCT/EP2018/056497
(87) Internationale Veröffentlichungsnummer: WO 2019/001783

(56) Entgegenhaltungen:
- EP-A1- 2 837 458
- EP-A1- 2 837 458
- WO-A1-03/024653
- WO-A1-03/024653
- WO-A1-2017/023060
- WO-A1-2017/023060
- DE-C2- 3 051 232
- DE-C2- 3 051 232
- FR-A1- 2 605 176
- FR-A1- 2 605 176
- US-A- 4 484 054
- US-A- 4 484 054
- US-A1- 2002 047 213
- US-A1- 2002 047 213

## Beschreibung

Die Erfindung betrifft ein Verfahren zur Herstellung einer Bauelementanordnung umfassend die Herstellung einer Drahtverbindung zwischen einer ersten Kontaktfläche und zumindest einer weiteren Kontaktfläche gemäß Anspruch 1. Des Weiteren betrifft die Erfindung eine mittels des Verfahrens hergestellte Bauelementanordnung. Vorrichtungen zur Herstellung von Drahtverbindungen sind seit langem, insbesondere unter der Bezeichnung "Drahtbonder", bekannt. Regelmäßig sind diese Vorrichtungen derart ausgebildet, dass, wie beispielsweise aus der US 8,657,181 B2 bekannt, sowohl die Positionierung eines Kontaktendes eines in einer Drahtführungskapillare geführten Drahts gegenüber den miteinander zu verbindenden Kontaktflächen als auch die Herstellung der Verbindung zwischen dem Draht und den Kontaktflächen durch das Drahtführungswerkzeug ausgeführt wird.

Zur Herstellung der Verbindung wird ein stempelartig ausgebildeter, regelmäßig auch als "wedge" bezeichneter Teil des Drahtführungswerkzeugs mit Ultraschall beaufschlagt, so dass der zwischen dem "wedge" und der Kontaktoberfläche angeordnete Draht durch die Ultraschallbeaufschlagung in einem Reibschweiß-Vorgang mit der Kontaktfläche verbunden wird.

Die Durchführung dieses Schweißvorgangs setzt neben der Ultraschallbeaufschlagung des "wedge", der infolge der Ultraschallbeaufschlagung oszillierende Schwingungen parallel zur Kontaktfläche ausführt, eine ausreichende Druckbeaufschlagung des Drahts voraus, so dass dieser mit einer entsprechenden Druckkraft gegen die Kontaktfläche gepresst werden muss. Aus dieser Art der Beaufschlagung resultiert eine entsprechende mechanische Beanspruchung der Kontaktoberfläche und des mit dieser Kontaktoberfläche versehenen Bauteils.

Weitere gattungsgemäße Drahtverbindungsvorrichtungen sowie Verfahren zur Herstellung einer Drahtverbindung sind jeweils aus der DE 30 51 232 C2, der US 4,484,054 A, der EP 2 837 458 A1 und der FR 2 605 176 A1 bekannt. WO 2017/023060 A1 offenbart eine Bauelementanordnung, in der zwischen einander zugewandten Rückseiten zweier aufeinander angeordneter Bauelemente eine Bauelementverbindung ausgebildet ist und zur Verbindung von Kontaktflächen der Bauelemente Drahtstrecken ausgebildet sind.

Aus dem Vorstehenden wird ersichtlich, dass die Herstellung einer Drahtverbindung mittels Ultraschallbonden eine entsprechende mechanische Belastbarkeit und auch Zugänglichkeit der Kontaktstelle voraussetzt. Daher wird das Ultraschallbonden in aller Regel auch dort eingesetzt, wo es darum geht, einen Draht mit einer gut zugänglichen Kontaktfläche auf einer fachterminologisch auch als Printed Circuit Board bekannten, mechanisch belastbaren Platine herzustellen.

Der vorliegenden Erfindung liegt die Aufgabe zugrunde, die Herstellung von Drahtverbindungen zwischen Kontakten auch in solchen Fällen zu ermöglichen, in denen eine schlechte Zugänglichkeit der Kontaktstelle gegeben ist oder auch ein elektrischer Kontakt zwischen einem Draht und einem Kontakt oder Kontaktkörper herzustellen ist, der mechanisch nicht belastet werden soll. Des Weiteren liegt der Erfindung die Aufgabe zugrunde, Bauelementanordnungen unter Verwendung derartig hergestellter Drahtverbindungen zu ermöglichen Zur Lösung dieser Aufgabe weist das erfindungsgemäße Verfahren die Merkmale des Anspruchs 1 auf.

Erfindungsgemäß wird abweichend von dem bekannten als Drahtbonder ausgeführten Drahtführungswerkzeug, das sowohl zur Positionierung des mit einer Kontaktfläche zu kontaktierenden Drahts dient als auch zur Herstellung des mechanischen Kontakts zwischen dem Draht und der Kontaktfläche durch Ultraschallbeaufschlagung des Drahts, ein Drahtführungswerkzeug verwendet, das lediglich zur Positionierung des Drahts gegenüber dem Kontakt, jedoch nicht zur Herstellung der Kontaktverbindung zwischen dem Draht und dem Kontakt, dient. Vielmehr erfolgt die Herstellung der sowohl elektrisch leitenden als auch mechanisch haltenden Verbindung mittels einer Benetzung eines zwischen der ersten Kontaktfläche und dem Kontaktende ausgebildeten Kontaktbereichs mit einer zumindest teilweise aufgeschmolzenen ersten, aus einem Lotmaterialformstück gebildeten Lotmaterialmenge zur Ausbildung einer ersten Lotmaterialverbindung, derart, dass eine mechanische, elektrisch leitende Verbindung zwischen der ersten Kontaktfläche und dem Kontaktende ausgebildet wird.

Nachfolgend wird das Drahtführungswerkzeug zu der weiteren Kontaktfläche bewegt, derart, dass ein Kontaktbereich zwischen einem Drahtstreckenende einer mittels der Bewegung des Drahtführungswerkzeugs zwischen der ersten Kontaktfläche und der zweiten Kontaktfläche ausgebildeten Drahtstrecke und der zweiten Kontaktfläche ausgebildet wird.

Anschließend erfolgt eine Benetzung des weiteren Kontaktbereichs mit einer zumindest teilweise aufgeschmolzenen zweiten, aus einem Lotmaterialformstück gebildeten Lotmaterialmenge zur Ausbildung einer weiteren Lotmaterialverbindung, derart, dass zwischen dem Drahtstreckenende und der weiteren Kontaktfläche eine mechanische, elektrisch leitende Verbindung ausgebildet wird. Die elektrisch leitende Verbindung wird derart gestaltet, dass zwischen einander zugewandten Rückseiten (93, 94) zweier aufeinander angeordneter Bauelemente (91, 92) eine Bauelementverbindung ausgebildet wird und sich zur Verbindung von Kontaktflächen (97, 98) der Bauelemente ausgebildete Drahtstrecken (99) bogenförmig über benachbarte Seitenränder der Bauelemente erstrecken.

Anschließend kann eine Abtrennung der Drahtstrecke von dem mit dem Drahtführungswerkzeug geführten Draht erfolgen. Die Abtrennung kann mechanisch oder etwa auch thermisch mittels Laserbeaufschlagung der beabsichtigten Trennstelle erfolgen.

Die erfindungsgemäße Differenzierung zwischen der Positionierung des Drahts gegenüber den Kontaktflächen mit Ausbildung eines Kontaktbereichs mittels eines Drahtführungswerkzeugs und Herstellung des elektrisch leitenden und mechanischen Kontakts zwischen dem Draht und den Kontaktflächen mittels einer Benetzung des Kontaktbereichs mit Lotmaterial unabhängig vom Drahtführungswerkzeug führt im Ergebnis dazu, dass die Kontaktfläche, die mit dem Draht verbunden werden soll, nicht mechanisch belastet wird. Aufgrund der Herstellung der Drahtverbindung zwischen der Kontaktfläche und dem Draht mittels Benetzung können insbesondere auch mehradrige Drähte oder auch druckempfindliche Drähte oder Leiter, wie insbesondere elektrisch leitfähig beschichtete Lichtleitfasern, mit der Kontaktfläche verbunden werden.

Abgesehen davon, dass somit eine Krafteinwirkung auf den Kontakt vermieden wird und somit auch besonders druckempfindliche Kontakte mit einem Draht elektrisch verbunden werden können, ist auch eine im Wesentlichen ebene Oberflächenausbildung des Kontakts, wie sie für die Durchführung des Ultraschallbondens wesentlich ist, nicht notwendig. Damit kann etwa auch eine Kontaktierung zwischen einem Draht und einer gewölbten oder gar sphärischen Kontaktoberfläche erfolgen. Insbesondere können auch Reihen- oder Serienkontaktierungen durchgeführt werden, bei denen eine Vielzahl von Kontaktflächen mit einem kontinuierlich ausgebildeten Drahtleiter verbunden werden.

Besonders vorteilhaft ist es, wenn die Benetzung des ersten und zweiten Kontaktbereichs dadurch erfolgt, dass ein Lotmaterialformstück mit Abstand zum Kontaktbereich in einer Ausgangsposition angeordnet wird, ein zumindest teilweises Aufschmelzen des Lotmaterialformstücks in der Ausgangsposition erfolgt, und das zumindest teilweise aufgeschmolzene Lotmaterialformstück aus der Ausgangsposition gegen den Kontaktbereich geschleudert wird. Hiermit können auch solche zwischen einer Kontaktfläche und dem Draht ausgebildeten Kontaktbereiche mit dem Lotmaterial benetzt werden, die mit einer mechanischen Transfereinrichtung zur Applikation des Lotmaterials im Kontaktbereich nicht zugänglich wären. Vielmehr ist es möglich, die Benetzung aus einer vom Kontaktbereich beanstandeten Ausgangsposition heraus durchzuführen.

Besonders vorteilhaft ist es, wenn zur Definition der Ausgangsposition das Lotmaterialformstück in einem Mundstück einer Kapillare oberhalb einer Ausgabeöffnung des Mundstücks angeordnet wird, wobei der Durchmesser der Ausgabeöffnung kleiner bemessen ist als der Durchmesser des Lotmaterialformstücks, das Aufschmelzen des Lotmaterialformstücks durch Beaufschlagung des Lotmaterialformstücks mit Laserenergie und die Ausgabe des aufgeschmolzenen Lotmaterialformstücks durch eine Gasdruckbeaufschlagung des Lotmaterialformstücks erfolgt.

Eine für die Beaufschlagung des Formstücks eingesetzte Lasereinrichtung kann vorzugsweise auch als Trenneinrichtung oder auch dazu verwendet werden, um vor der Benetzung des auf der Kontaktfläche angeordneten Drahtes eine Isolierung des Drahtes zu entfernen, so dass auch isolierte Drähte zur Durchführung des Verfahrens verwendet werden können.

Das erfindungsgemäße Verfahren kann mit einer Vorrichtung umfassend ein Drahtführungswerkzeug zur Positionierung eines Kontaktendes eines Drahts gegenüber einer ersten Kontaktfläche und Ausbildung einer Drahtstrecke zwischen der ersten Kontaktfläche und zumindest einer weiteren Kontaktfläche sowie Positionierung eines Drahtstreckenendes gegenüber der weiteren Kontaktfläche und eine Lotmaterialapplikationseinrichtung zur Applikation eines zumindest teilweise aufgeschmolzenen Lotmaterialformstücks in einem zwischen dem Kontaktende und der ersten Kontaktfläche ausgebildeten Kontaktbereich und einem zwischen dem Drahtstreckenende und der weiteren Kontaktfläche ausgebildeten Kontaktbereich ausgeführt werden.

Die Vorrichtung kann eine Trenneinrichtung zur Abtrennung der Drahtstrecke aufweisen.

Die Lotmaterialapplikationseinrichtung kann unabhängig von dem Drahtführungswerkzeug ausgebildet sein, so dass die Positionierung der Applikationseinrichtung unabhängig vom Drahtführungswerkzeug erfolgen kann, also beispielsweise in einander nachfolgenden Kontaktpositionen des Drahtführungswerkzeugs die Applikation der Lotmaterialformstücke aus unterschiedlichen Ausgangspositionen erfolgen kann, die die jeweils beste Benetzbarkeit des Kontaktbereichs ermöglichen.

Wenn das Drahtführungswerkzeug eine Drahtführungskapillare zur Ausgabe eines mittels einer Vorschubeinrichtung aus einer an einem Mundstück der Drahtführungskapillare ausgebildeten Ausgabeöffnung geförderten Drahts aufweist, ist eine exakte Positionierung eines aus der Ausgabeöffnung herausragenden Kontaktendes gegenüber der zu kontaktierenden Kontaktfläche gegeben.

Die Trenneinrichtung kann zumindest teilweise durch das Mundstück der Drahtführungskapillare gebildet sein, so dass das Mundstück gleich mehrere Funktionen ausführt.

Die Trenneinrichtung kann ein Trennelement aufweisen, das gegenüber dem Mundstück der Drahtführungskapillare bewegbar ausgebildet ist, so dass bei Ausführung des Trennelements als eine erste Messerschneide der Trenneinrichtung das Mundstück der Drahtführungskapillare eine Gegenschneide ausbilden kann.

Die Drahtführungskapillare kann über einen Grundkörper des Drahtführungswerkzeugs starr mit einem Drahtniederhalter verbunden sein, der durch einen mit dem Trennelement versehenen Zwischenraum vom Mundstück der Drahtführungskapillare beabstandet ist. Hierdurch ist eine besonders kompakte Ausgestaltung des mit mehrfachen Funktionen versehenen Drahtführungswerkzeugs möglich.

Die erfindungsgemäße Bauelementanordnung weist eine Mehrzahl von insbesondere als Chip ausgeführten elektronischen Bauelementen auf, wobei die Bauelemente in einer Stapelanordnung angeordnet sind und auf Anschlussseiten der Bauelemente angeordnete Kontaktflächen mit einer gemäß einem der Ansprüche 1 bis 4 hergestellten Drahtverbindung miteinander verbunden sind, derart, dass zwischen einer ersten Lotmaterialverbindung, die eine erste Kontaktfläche des ersten Bauelements mit einem Kontaktende eines Drahts verbindet, und einer zweiten Lotmaterialverbindung, die eine zweite Kontaktfläche eines weiteren Bauelements mit dem Draht verbindet, eine Drahtstrecke ausgebildet ist.

In einer vorteilhaften Ausführungsform, die nicht von der Erfindung umfasst ist, können die Bauelemente eine pyramidenförmige Stapelanordnung ausbilden, derart, dass zwischen einer Anschlussseite und einer Rückseite zweier aufeinander angeordneter Bauelemente eine Bauelementverbindung ausgebildet ist und sich zur Verbindung von Kontaktflächen der Bauelemente ausgebildete Drahtstrecken kaskadenartig über benachbarte Seitenränder der Bauelemente erstrecken.

Erfindungsgemäß ist zwischen einander zugewandten Rückseiten zweier aufeinander angeordneter Bauelemente der Bauelementanordnung eine Bauelementverbindung ausgebildet, und zur Verbindung von Kontaktflächen der Bauelemente ausgebildete Drahtstrecken erstrecken sich bogenförmig über benachbarte Seitenränder der Bauelemente.

Nachfolgend werden eine bevorzugte Variante des erfindungsgemäßen Verfahrens sowie eine bevorzugte Ausführungsform der dabei zum Einsatz kommenden Vorrichtung und vorteilhafte Bauelementanordnungen näher erläutert.

Es zeigen:
Fig. 1die Herstellung einer Drahtverbindung zwischen einem Draht und einem Kontaktpin eines mit einer Mehrzahl von Kontaktpins versehenen Kontaktsteckers mittels einer ersten Ausführungsform einer Drahtverbindungsvorrichtung;
Fig. 2die Herstellung einer Verbindung zwischen einem Draht und einer Kontaktfläche einer im Kontaktstecker aufgenommenen Kontaktplatine;
Fig. 3 bis 5 die Herstellung einer Drahtverbindung mittels einer zweiten Ausführungsform einer Drahtverbindungsvorrichtung;
Fig. 6eine Bauelementanordnung in einer ersten Ausführungsform, die nicht unter die beigefügten Ansprüche fällt;
Fig. 7eine erfindungsgemäße Bauelementanordnung.

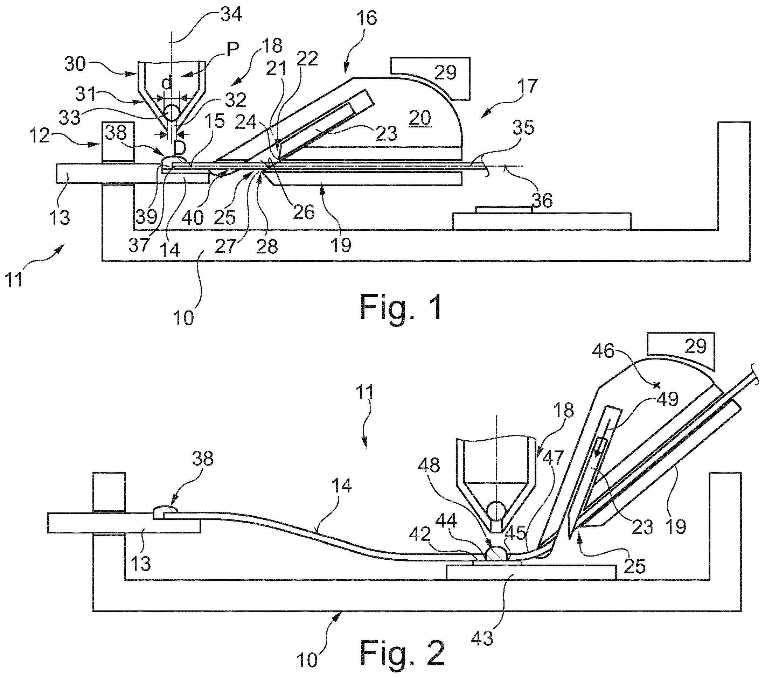

Fig. 1 zeigt in schematischer Darstellung ein schalenförmig ausgebildetes Gehäuseteil 10 eines Kontaktsteckers 11, wobei in dem Gehäuseteil 10 auf einer Frontseite 12, also der Seite, die einer hier nicht näher dargestellten Kontaktbuchse, die zur Kombination mit dem Kontaktstecker 11 vorgesehen ist, zugewandt ist, eine Mehrzahl von Kontaktpins 13 vorgesehen sind, von denen zur Vereinfachung der Darstellung hier lediglich ein Kontaktpin 13 gezeigt ist.

Der Kontaktpin 13 weist an seinem hinteren, innerhalb des Gehäuseteils 10 angeordneten Anschlussteil 14 eine hier durch eine Abflachung gebildete Kontaktfläche 15 auf. Oberhalb bzw. rechts von der Kontaktfläche 15 befindet sich eine Drahtverbindungsvorrichtung 16, die ein Drahtführungswerkzeug 17 sowie eine Lotmaterialapplikationseinrichtung 18 umfasst.

Das Drahtführungswerkzeug 17 weist eine Drahtführungskapillare 19 sowie einen über einen Grundkörper 20 mit der Drahtführungskapillare 19 verbundenen Niederhalter 21 auf. In einem zwischen dem Niederhalter 21 und der Drahtführungskapillare 19 ausgebildeten Zwischenraum 22 ist ein hier als Messerschneide mit einer Schneidkante 24 ausgebildetes Trennelement 23 aufgenommen.

Die Drahtführungskapillare 19 weist ein Mundstück 25 auf, das benachbart einer Ausgabeöffnung 26 mit einer Gegenschneidkante 27 versehen ist, die zusammen mit dem mit der Schneidkante 24 versehenen Trennelement 23 eine Trenneinrichtung 28 ausbildet.

Zur Ausführung einer mehrachsigen Bewegung des Drahtführungswerkzeugs 17 ist der Grundkörper 20 mit einer Koppeleinrichtung 29 versehen, die die Verbindung des Drahtführungswerkzeugs 17 mit einer nicht näher dargestellten Handachse einer Robotereinrichtung ermöglicht.

Die Lotmaterialapplikationseinrichtung 18 weist eine Applikationskapillare 30 mit einem Mundstück 31 auf, das mit einer Ausgabeöffnung 32 versehen ist. Zur Beaufschlagung eines im Mundstück 31 oberhalb der Ausgabeöffnung 32 aufgenommenen Lotmaterialformstücks 33 ist die Lotmaterialapplikationseinrichtung 18 mit einer hier nicht näher dargestellten, längs einer Kanalachse 34 der Applikationskapillare 30 Laserstrahlung emittierenden Lasereinrichtung versehen. Die Lotmaterialapplikationseinrichtung 18 kann ebenso wie das Drahtführungswerkzeug 17 an einer Handachse einer Robotereinrichtung zur Ausführung einer mehrachsigen Bewegung angeschlossen sein.

Sowohl das Drahtführungswerkzeug 17 als auch die Lotmaterialapplikationseinrichtung 18 sind jeweils mit einer hier nicht näher dargestellten Zuführeinrichtung versehen, die im Falle des Drahtführungswerkzeugs 17 eine hier nicht näher dargestellte Vorschubeinrichtung aufweist, mit der ein in der Drahtführungskapillare 19 längsgeführter Draht 35 in Richtung einer Kanalachse 36 vorbewegt und dabei von einer ebenfalls nicht näher dargestellten Drahtvorratsrolle abgespult wird.

Im Falle der Lotmaterialapplikationseinrichtung 18 ist die Zuführeinrichtung mit einem Vorratsreservoir zur Aufnahme von Lotmaterialformstücken 33 versehen, die mittels der Zuführeinrichtung dem Lotmaterialreservoir vereinzelt entnommen und in die in Fig. 1 dargestellte Ausgangsposition P für die Applikation des Lotmaterialformstücks 33 gefördert werden.

Die in Fig. 1 dargestellte Konfiguration zeigt die Drahtverbindungsvorrichtung 16 unmittelbar nach Ausbildung einer zwischen einem Kontaktende 37 des Drahts 35 und der Kontaktfläche 15 des Kontaktpins 13 hergestellten Lotmaterialverbindung 38.

Zur Herstellung der in Fig. 1 dargestellten Lotmaterialverbindung 38 wird das aus der Drahtführungskapillare 19 herausgeführte Kontaktende 37 zur Ausbildung eines Kontaktbereichs 39 auf der Kontaktfläche 15 positioniert. Dabei ist der Draht 35 durch eine im vorliegenden Fall nach unten offene Aufnahmenut 40 des Niederhalters 21 hindurchgeführt. Wenn sich das Kontaktende 37 in der in Fig. 1 dargestellten Kontaktposition befindet, erfolgt ein zumindest teilweises Aufschmelzen des im Mundstück 31 der Applikationskapillare 30 aufgenommenen Lotmaterialformstücks 33, derart, dass mittels einer Gasdruckbeaufschlagung des Lotmaterialformstücks 33 das Lotmaterialformstück 33, dessen Durchmesser d vor dem zumindest teilweisen Aufschmelzen größer ist als der Durchmesser D der Ausgabeöffnung 32, durch die Ausgabeöffnung 32 ausgetrieben und gegen den Kontaktbereich 39 geschleudert wird. Infolge des Auftreffens des zumindest teilweise aufgeschmolzenen Lotmaterialformstücks 33 auf den Kontaktbereich 39 ergibt sich die in Fig. 1 dargestellte Benetzung desselben.

Nach Herstellung der in Fig. 1 dargestellten Lotmaterialverbindung 38 erfolgt eine Bewegung des Drahtführungswerkzeugs 17 bzw. des Grundkörpers 20 des Drahtführungswerkzeugs 17 in die in Fig. 2 dargestellte zweite Kontaktposition, wobei aufgrund der mechanischen Fixierung des Kontaktendes 37 des Drahts 35 an dem Kontaktpin 13 eine Drahtstrecke 41 zwischen dem Kontaktpin 13 und dem Mundstück 25 der Drahtführungskapillare 19 des Drahtführungswerkzeugs 17 ausgebildet wird, derart, dass zwischen einer Kontaktfläche 42 einer im Gehäuseteil 10 aufgenommenen Platine 43 und einem Drahtstreckenende 45 ein weiterer Kontaktbereich 44 ausgebildet wird, in dem der Draht 35 mit dem Drahtstreckenende 45 auf der Kontaktfläche 42 aufliegt.

Um das Aufliegen oder Anliegen des Verbindungsbereichs 45 auf der Kontaktfläche 42 mit Ausbildung des Kontaktbereichs 44 zu unterstützen, ist im vorliegenden Fall der Grundkörper 20 um eine Nickachse 46 verschwenkt, derart, dass der Niederhalter 21 nunmehr eine leichte Abwinkelung im Verlauf der Drahtstrecke 35 bewirkt.

In der in Fig. 2 dargestellten Kontaktposition des Drahtführungswerkzeugs 17 tritt dann erneut die Lotmaterialapplikationseinrichtung 18 auf die bereits vorstehend erläuterte Art und Weise in Aktion, derart, dass nunmehr zur Ausbildung einer Lotmaterialverbindung 48 ein weiteres Lotmaterialformstück 33 gegen den Kontaktbereich 44 zur Ausbildung einer Benetzung des Kontaktbereichs 44 geschleudert wird.

Anschließend erfolgt eine Abtrennung der Drahtstrecke 41 durch eine axiale Schneidbewegung 49 der Messerschneide 23, wobei der Draht 35 durchtrennt wird.

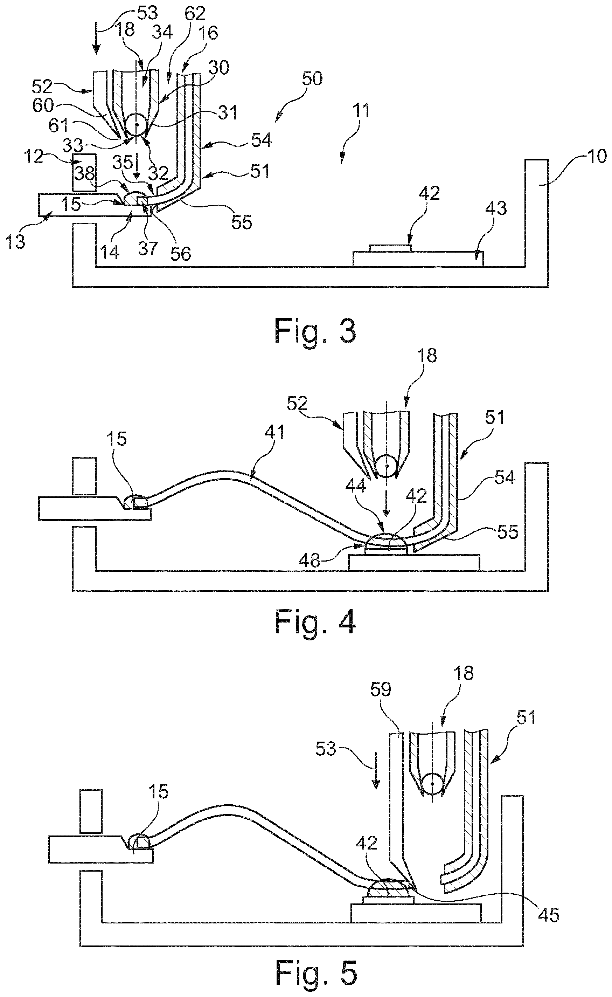

In den Figuren 3 bis 5 ist in einer weiteren Ausführungsform eine Drahtverbindungsvorrichtung 50 dargestellt, die abweichend von der in den Figuren 1 und 2 dargestellten Drahtverbindungsvorrichtung 16 eine Anordnung eines Drahtführungswerkzeugs 51 und einer Trenneinrichtung 52 aufweist, derart, dass eine im vorliegenden Fall identisch mit der Lotmaterialapplikationseinrichtung 18 ausgebildete und daher vorliegend mit identischen Bezugszeichen versehene Lotmaterialapplikationseinrichtung 18 in einem zwischen dem Drahtführungswerkzeug 51 und der Trenneinrichtung 52 ausgebildeten Zwischenraum 62 angeordnet ist.

Insbesondere das Drahtführungswerkzeug 51, die Lotmaterialapplikationseinrichtung 18 und die Trenneinrichtung 52 der in den Fig.3 bis 5 dargestellten Drahtverbindungsvorrichtung können bei Bedarf mehrachsig und insbesondere unabhängig voneinander im Raum bewegbar ausgebildet sein, um unterschiedlich im Raum orientierte Kontaktflächen mit einander verbinden zu können.

Das Drahtführungswerkzeug 51 weist eine im vorliegenden Fall vertikal orientierte Drahtführungskapillare 54 auf, die an ihrem freien Ende mit einem abgewinkelten Mundstück 55 mit einer Ausgabeöffnung 56 versehen ist. Wie aus Fig. 3 ersichtlich, ermöglicht die Drahtführungskapillare 54 bei im Wesentlichen vertikaler Anordnung eine Ausrichtung eines Kontaktendes 37 des Drahtes 35 auf die Kontaktfläche 15, derart, dass das Kontaktende 37 in einer Überdeckung mit der Kontaktfläche 15 angeordnet ist und gleichzeitig eine durch die Kanalachse 34 der Lotmaterialapplikationseinrichtung 18 definierte Applikationsachse schneidet. In dieser Konfiguration kann, wie vorstehend bereits Bezug nehmend auf die Fig. 1 erläutert, eine Applikation eines zumindest teilweise aufgeschmolzenen Lotmaterialformstücks 33 auf die Kontaktfläche 15 erfolgen.

Nach Herstellung der ersten Lotmaterialverbindung 38 zwischen dem Kontaktende 37 und der Kontaktfläche 15 erfolgt zur Ausbildung der Drahtstrecke 41, wie ebenfalls bereits Bezug nehmend auf die Figuren 1 und 2 beschrieben, eine Bewegung des Drahtführungswerkzeugs 51 in die in Fig. 4 dargestellte zweite Kontaktposition, derart, dass zwischen der weiteren Kontaktfläche 42 und dem Drahtstreckenende 45 ein weiterer Kontaktbereich 44 ausgebildet wird, in dem der Draht mit dem Drahtstreckenende 45 auf der Kontaktfläche 42 aufliegt.

In der in Fig. 4 dargestellten Kontaktposition des Drahtführungswerkzeugs 51 erfolgt zur Ausbildung einer weiteren Lotmaterialverbindung 48 die Applikation eines weiteren, zumindest teilweise aufgeschmolzenen Lotmaterialformstücks 33 gegen den Kontaktbereich 44, so dass eine Benetzung des Kontaktbereichs 44 und des Drahtes 35 erfolgt. Für den Fall, dass es sich bei der weiteren Lotmaterialverbindung 48 um die letzte von mehreren zwischen dem fortlaufend aus dem Mundstück 55 des Drahtführungswerkzeugs 51 geführten Draht 35 und Kontaktflächen hergestellte Lotmaterialverbindung handelt, erfolgt anschließend eine Abtrennung der Drahtstrecke durch eine Schneidbewegung 53 der Trenneinrichtung 52, derart, dass eine an einem Trennelement 60 der Trenneinrichtung 59 ausgebildete Schneidkante 61 den Draht 35, wie in Fig. 5 dargestellt, durchtrennt.

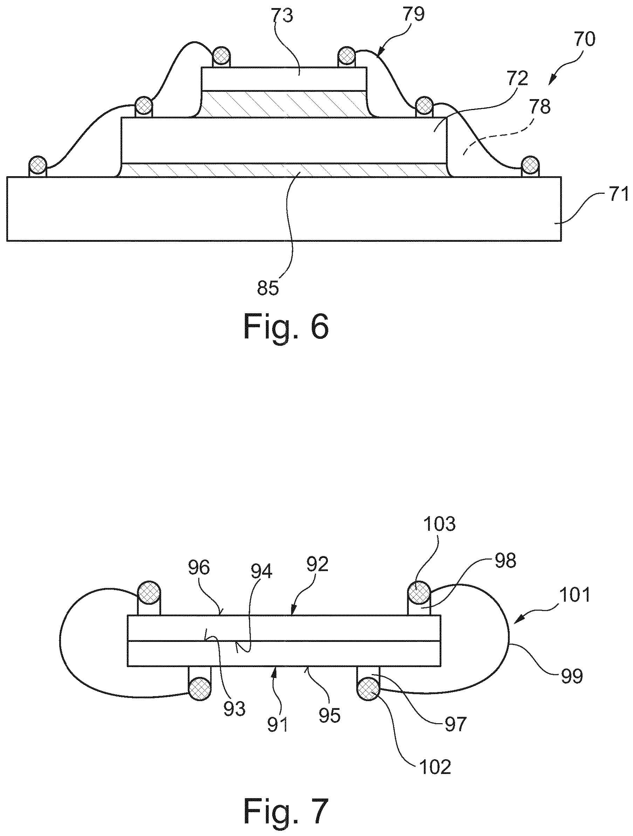

Fig. 6 zeigt eine Bauelementanordnung 70 mit drei übereinander in einer pyramidenförmigen Stapelanordnung angeordneten, hier als Chips ausgeführten Bauelementen 71, 72, 73. Zur Fixierung der Bauelemente 71, 72, 73 aufeinander ist bei benachbarten Bauelementen zwischen einer mit Kontaktflächen 75, 76, 77 versehenen Anschlussseite 83 und einer Rückseite 84 eine hier durch einen Underfiller ausgebildete Bauelementverbindung 85 vorgesehen.

Die Bauelementanordnung 70 weist unter vorzugsweiser Verwendung einer in den Figuren 3 bis 5 dargestellten Drahtverbindungsvorrichtung 50 hergestellte Drahtverbindungen auf, wobei die jeweils an einem Seitenrand der Anschlussseite 83 vorgesehenen Kontaktflächen 75, 76, 77 über Drahtstrecken 78 derart miteinander verbunden sind, dass zwischen einem die Drahtstrecke 78 ausbildenden Draht 79 und den Kontaktflächen 75, 76, 77 jeweils eine Lotmaterialverbindung 80, 81 und 82 ausgebildet ist.

Fig. 7 zeigt eine ebenfalls vorzugsweise mit der Drahtverbindungseinrichtung 50 hergestellte Bauelementanordnung 90, die zwei hier ebenfalls als Chips ausgeführte Bauelemente 91, 92 aufweist, welche über ihre Rückseiten 93, 94 miteinander verbunden sind, derart, dass Anschlussseiten 95, 96 der Bauelemente 91, 92, die im vorliegenden Fall mit jeweils zwei Kontaktflächen 97, 98 versehen sind, jeweils eine Außenseite der Bauelementanordnung 90 ausbilden. Zur Verbindung von jeweils zwei einander zugeordneten, auf den voneinander abgewandten Anschlussseiten 95, 96 angeordneten Kontaktflächen 97, 98 sind diese über Drahtstrecken 99 derart miteinander verbunden, dass ein die Drahtstrecken 99 ausbildender Draht 101 über eine erste, auf der unteren Anschlussseite 95 mit der Kontaktfläche 97 ausgebildete Lotmaterialverbindung 102 und über eine zweite, mit der auf der oberen Kontaktseite 94 angeordneten Kontaktfläche 96 ausgebildeten Lotmaterialverbindung 103 eine Drahtverbindung zwischen den Bauelementen 91, 92 ausbildet.

## Patentansprüche

1. Verfahren zur Herstellung einer Bauelementanordnung, umfassend die Herstellung einer Drahtverbindung zwischen einer ersten Kontaktfläche (15, 75, 97) eines ersten Bauelements (91) und zumindest einer weiteren Kontaktfläche (42, 76, 77, 98) eines weiteren Bauelements (92), bei dem ein Kontaktende (37) eines Drahts (35, 79, 101) mittels eines Drahtführungswerkzeugs (17, 51) in einer Kontaktposition gegenüber der ersten Kontaktfläche (15, 75, 97) positioniert wird und nachfolgend eine Benetzung eines zwischen der ersten Kontaktfläche (15, 75, 97) und dem Kontaktende (37) ausgebildeten Kontaktbereichs (39) mit einer zumindest teilweise aufgeschmolzenen ersten, aus einem Lotmaterialformstück (33) gebildeten Lotmaterialmenge zur Ausbildung einer ersten Lotmaterialverbindung (38, 80, 102) erfolgt, derart, dass eine mechanische, elektrisch leitende Verbindung zwischen der ersten Kontaktfläche (15, 75, 97) und dem Kontaktende (37) ausgebildet wird,
nachfolgend das Drahtführungswerkzeug (17, 51) zu der weiteren Kontaktfläche (42) bewegt wird, derart, dass ein Kontaktbereich (44) zwischen einem Drahtstreckenende (45) einer mittels der Bewegung des Drahtführungswerkzeugs (17, 51) zwischen der ersten Kontaktfläche (15, 75, 97) und der weiteren Kontaktfläche (42, 76, 77, 98) ausgebildeten Drahtstrecke (41) und der weiteren Kontaktfläche (42, 76, 77, 98) ausgebildet wird,
und nachfolgend eine Benetzung des zweiten Kontaktbereichs (44) mit einer zumindest teilweise aufgeschmolzenen zweiten, aus einem Lotmaterialformstück (33) gebildeten Lotmaterialmenge zur Ausbildung zumindest einer weiteren Lotmaterialverbindung (48, 81, 82, 103) erfolgt, derart, dass zwischen dem Drahtstreckenende (45) und der weiteren Kontaktfläche (42, 76, 77, 98) eine mechanische,
elektrisch leitende Verbindung ausgebildet wird,
**dadurch gekennzeichnet, dass**
zwischen einander zugewandten Rückseiten (93, 94) der zwei aufeinander angeordneten Bauelemente (91, 92) eine Bauelementverbindung ausgebildet wird und sich zur Verbindung von Kontaktflächen (97, 98) der Bauelemente ausgebildete Drahtstrecken (99) bogenförmig über benachbarte Seitenränder der Bauelemente erstrecken.

2. Verfahren nach Anspruch 1,
**dadurch gekennzeichnet,**
**dass** nachfolgend der Ausbildung der weiteren Lotmaterialverbindung (48, 81, 82, 103) eine Abtrennung der Drahtstrecke (41, 78, 99) von dem mit dem Drahtführungswerkzeug (17, 51) geführten Draht (35, 79, 101) erfolgt.

3. Verfahren nach Anspruch 1 oder 2,
**dadurch gekennzeichnet,**
**dass** die Benetzung des ersten und zweiten Kontaktbereichs (39, 44) dadurch erfolgt, dass ein Lotmaterialformstück (33) mit Abstand zum Kontaktbereich in einer Ausgangsposition angeordnet wird, ein zumindest teilweises Aufschmelzen des Lotmaterialformstücks (33) in der Ausgangsposition erfolgt und das zumindest teilweise aufgeschmolzene Lotmaterialformstück (33) aus der Ausgangsposition gegen den Kontaktbereich (39, 44) geschleudert wird.

4. Verfahren nach Anspruch 3,
**dadurch gekennzeichnet,**
**dass** zur Definition der Ausgangsposition das Lotmaterialformstück (33) in einem Mundstück (31) einer Applikationskapillare (30) oberhalb einer Ausgabeöffnung (32) des Mundstücks (31) angeordnet wird, wobei der Durchmesser D der Ausgabeöffnung (32) kleiner bemessen ist als der Durchmesser d des Lotmaterialformstücks (33), das Aufschmelzen des Lotmaterialformstücks (33) durch Beaufschlagung des Lotmaterialformstücks (33) mit Laserenergie und die Ausgabe des aufgeschmolzenen Lotmaterialformstücks (33) durch eine Gasdruckbeaufschlagung des Lotmaterialformstücks (33) erfolgt.

5. Bauelementanordnung (70, 90) hergestellt gemäß einem der Ansprüche 1 bis 4, mit einer Mehrzahl von insbesondere als Chip ausgeführten elektronischen Bauelementen (71, 72, 73, 91, 92), wobei die Bauelemente in einer Stapelanordnung angeordnet sind und auf Anschlussseiten (83, 95, 96) der Bauelemente angeordnete Kontaktflächen (75, 76, 77, 97, 98) mit einer Drahtverbindung miteinander verbunden sind, derart, dass zwischen einer ersten Lotmaterialverbindung (80, 102), die eine erste Kontaktfläche (75, 97) des ersten Bauelements (71, 91) mit einem Kontaktende eines Drahts (79, 101) verbindet, und einer zweiten Lotmaterialverbindung (81), die eine zweite Kontaktfläche (76, 98) eines weiteren Bauelements (72, 73, 92) mit dem Draht verbindet, eine Drahtstrecke (78, 99) ausgebildet ist, wobei zwischen einander zugewandten Rückseiten (93, 94) der zwei aufeinander angeordneten Bauelemente (91, 92) eine Bauelementverbindung ausgebildet ist und sich zur Verbindung von Kontaktflächen (97, 98) der Bauelemente ausgebildete Drahtstrecken (99) bogenförmig über benachbarte Seitenränder der Bauelemente erstrecken.

## Claims

1. A method for producing a component arrangement, comprising establishing a wire connection between a first contact surface (15, 75, 97) of a first component (91) and at least one other contact surface (42, 76, 77, 98) of another component (92), in which a contact end (37) of a wire (35, 79, 101) is positioned in a contact position relative to the first contact surface (15, 75, 97) by means of a wire guiding tool (17, 51) and a contact area (39), which is formed between the first contact surface (15, 75, 97) and the contact end (37), is subsequently wetted using an at least partially fused first solder material amount formed from a solder material molded piece (33) in order to establish a first solder material connection (38, 80, 102) in such manner that a mechanical, electrically conductive connection is established between the first contact surface (15, 75, 97) and the contact end (37),
the wire guiding tool (17, 51) is subsequently moved to the other contact surface (42) in such a manner that a contact area (44) is formed between a wire section end (45) of a wire section (41), which is formed between the first contact surface (15, 75, 97) and the other contact surface (42, 76, 77, 98) by means of the movement of the wire guiding tool (17, 51), and the other contact surface (42, 76, 77, 98),
and the second contact area (44) is subsequently wetted using an at least partially fused second solder material amount formed from a solder material molded piece (33) in order to establish at least one other solder material connection (48, 81, 82, 103) in such a manner that a mechanical electrically conductive connection is established between the wire section end (45) and the other contact surface (42, 76, 77, 98),
**characterized in that**
a component connection is established between opposing rear sides (93, 94) of the two components (91, 92) arranged on top of each other and wire sections (99) formed for connecting contact surfaces (97, 98) of the components extend over adjacent lateral edges of the components in arches.

2. The method according to claim 1,
**characterized in that**
after establishing the other solder material connection (48, 81, 82, 103), the wire section (41, 78, 99) is separated from the wire (35, 79, 101) which is guided by means of the wire guiding tool (17, 51).

3. The method according to claim 1 or 2,
**characterized in that**
the first contact area and the second contact area (39, 44) are wetted by a solder material molded piece (33) being arranged in an initial position at a distance from the contact area, said solder material molded piece (33) being at least partially fused in the initial position and said at least partially fused solder material molded piece (33) being thrown against the contact area (39, 44) from the initial position.

4. The method according to claim 3,
**characterized in that**
for defining the initial position, the solder material molded piece (33) is arranged in a mouthpiece (31) of an application capillary (30) above a dispenser opening (32) of the mouthpiece (31), the diameter D of the dispenser opening (32) being smaller than the diameter d of the solder material molded piece (33), said solder material molded piece (33) being fused by laser energy being applied to the solder material molded piece (33) and the fused solder material molded piece (33) being dispensed by means of gas pressure being applied to the solder material molded piece (33).

5. A component arrangement (70, 90), produced according to any one of the claims 1 to 4, having a plurality of electronic components (71, 72, 73, 91, 92) realized in particular as chips, said electronic components being arranged in a stack arrangement, and contact surfaces (75, 76, 77, 97, 98) arranged on connection sides (83, 95, 96) of the components being connected to each other using a wire connection in such a manner that a wire section (78, 99) is formed between a first solder material connection (80, 102), which connects a first contact surface (75, 97) of the first component (71, 91) to a contact end of a wire (79, 101), and a second solder material connection (81), which connects a second contact surface (76, 98) of another component (72, 73, 92) to the wire, wherein a component connection is established between opposing rear sides (93, 94) of the two components (91, 92) arranged on top of each other, and wire sections (99) formed for connecting contact surfaces (97, 98) of the components extend over adjacent lateral edges of the components in arches.

## Revendications

1. Procédé de fabrication d'un agencement de composants, comprenant l'établissement d'une connexion de câble entre une première surface de contact (15, 75, 97) d'un premier composant (91) et au moins une autre surface de contact (42, 76, 77, 98) d'un autre composant (92), dans lequel une extrémité de contact (37) d'un câble (35, 79, 101) est positionnée dans une position de contact par rapport à la première surface de contact (15, 75, 97) au moyen d'un outil (17, 51) de guidage de câble et une zone de contact (39), qui est formée entre la première surface de contact (15, 75, 97) et l'extrémité de contact (37), est ensuite mouillée à l'aide d'une première quantité de matériau à souder au moins partiellement fondue formée à partir d'une pièce façonnée (33) en matériau à souder afin d'établir une première connexion (38, 80, 102) de matériau à souder de telle manière qu'une connexion mécanique et électriquement conductrice est établie entre la première surface de contact (15, 75, 97) et l'extrémité de contact (37),
l'outil (17, 51) de guidage de câble est ensuite déplacé vers l'autre surface de contact (42) de telle manière qu'une zone de contact (44) est formée entre une extrémité (45) de partie de câble d'une partie de câble (41), qui est formée entre la première surface de contact (15, 75, 97) et l'autre surface de contact (42, 76, 77, 98) au moyen du mouvement de l'outil (17, 51) de guidage de câble, et l'autre surface de contact (42, 76, 77, 98),
et la deuxième zone de contact (44) est ensuite mouillée à l'aide d'une deuxième quantité de matériau à souder au moins partiellement fondue formée à partir d'une pièce façonnée (33) en matériau à souder afin d'établir au moins une autre connexion (48, 81, 82, 103) de matériau à souder de telle manière qu'une connexion mécanique électriquement conductrice est établie entre l'extrémité (45) de partie de câble et l'autre surface de contact (42, 76, 77, 98),
**caractérisé en ce**
**qu'**une connexion de composants est établie entre les faces arrières (93, 94) opposées des deux composants (91, 92) disposés l'un au-dessus de l'autre et des parties de câble (99) formées pour connecter les surfaces de contact (97, 98) des composants s'étendent en arcs sur les bords latéraux adjacents des composants.

2. Procédé selon la revendication 1,
**caractérisé en ce**
**qu'**après avoir établi l'autre connexion (48, 81, 82, 103) de matériau à souder, la partie de câble (41, 78, 99) est séparée du câble (35, 79, 101) qui est guidé au moyen de l'outil (17, 51) de guidage de câble.

3. Procédé selon la revendication 1 ou la revendication 2,
**caractérisé en ce que**
la première zone de contact et la deuxième zone de contact (39, 44) sont mouillées par une pièce façonnée (33) en matériau à souder disposée dans une position initiale étant disposée à distance de la zone de contact, ladite pièce façonnée (33) en matériau à souder étant fondue au moins partiellement dans la position initiale et ladite pièce façonnée (33) en matériau à souder au moins partiellement fondue étant lancée contre la zone de contact (39, 44) à partir de la position initiale.

4. Procédé selon la revendication 3,
**caractérisé en ce que**
pour définir la position initiale, la pièce façonnée (33) en matériau à souder est disposée dans un embout (31) d'un capillaire d'application (30) au-dessus d'une ouverture de distributeur (32) de l'embout (31), le diamètre D de l'ouverture de distributeur (32) étant inférieur au diamètre d de la pièce façonnée (33) en matériau à souder, ladite pièce façonnée (33) en matériau à souder étant fondue par une énergie laser appliquée à la pièce façonnée (33) en matériau à souder et la pièce façonnée (33) en matériau à souder fondue étant distribuée au moyen d'une pression de gaz appliquée à la pièce façonnée (33) en matériau à souder.

5. Agencement de composants (70, 90), fabriqué selon l'une quelconque des revendications 1 à 4, comportant une pluralité de composants (71, 72, 73, 91, 92) électroniques réalisés notamment sous forme de puces, lesdits composants électroniques étant montés en pile, et des surfaces de contact (75, 76, 77, 97, 98) disposées sur des faces de connexion (83, 95, 96) des composants étant reliées entre elles à l'aide d'une connexion de câble de telle manière qu'une partie de câble (78, 99) est formée entre une première connexion de matériau à souder (80, 102), qui relie une première surface de contact (75, 97) du premier composant (71, 91) à une extrémité de contact d'un câble (79, 101), et une deuxième connexion de matériau à souder (81), qui relie une deuxième surface de contact (76, 98) d'un autre composant (72, 73, 92) au câble, dans lequel une connexion de composants est établie entre les faces (93, 94) arrières opposées des deux composants (91, 92) disposés l'un au-dessus de l'autre, et les parties de câble (99) formées pour connecter les surfaces de contact (97, 98) des composants s'étendent en arcs sur les bords latéraux adjacents des composants.
